# EUROPÄISCHE PATENTSCHRIFT

(11) **EP 1 920 470 B1**
(45) Veröffentlichungstag und Bekanntmachung des Hinweises auf die Patenterteilung: **04.04.2018**
(21) Anmeldenummer: 06775910.0
(22) Anmeldetag: 24.08.2006
(51) Int. Cl.: H01L 33/00

(54) **VERFAHREN ZUR HERSTELLUNG EINES OBERFLÄCHENMONTIERBAREN OPTOELEKTRONISCHEN HALBLEITERBAUELEMENTS**
METHOD FOR MANUFACTURING A SURFACE-MOUNTED OPTOELECTRONIC SEMICONDUCTOR DEVICE
PROCEDE DE REALISATION D'UN DISPOSITIF A SEMI-CONDUCTEUR OPTOELECTRONIQUE POUVANT ETRE MONTE EN SURFACE

(30) Priorität: 30.08.2005 DE 102005041064
(43) Veröffentlichungstag der Anmeldung: 14.05.2008
(73) Patentinhaber: OSRAM Opto Semiconductors GmbH, 93055 Regensburg (DE)
(72) Erfinder: BRAUNE, Bert, 93173 Wenzenbach (DE); BRUNNER, Herbert, 93161 Sinzing (DE); HÖFER, Thomas, 93138 Lappersdorf (DE); JÄGER, Harald, 93049 Regensburg (DE); SCHWARZ, Raimund, 93053 Regensburg (DE)
(74) Vertreter: Epping - Hermann - Fischer
(86) Internationale Anmeldenummer: PCT/DE2006/001492
(87) Internationale Veröffentlichungsnummer: WO 2007/025515

(56) Entgegenhaltungen:
- EP-A2- 1 162 668
- WO-A-2005/064696
- WO-A2-02/084749
- DE-A1- 10 237 403
- JP-A- 8 298 345
- JP-A- H11 307 675
- JP-A- 2000 077 725
- JP-A- 2001 244 508
- US-A- 3 609 475
- US-A1- 2002 005 573
- US-A1- 2002 030 268
- US-A1- 2002 093 081
- US-A1- 2003 107 316
- US-A1- 2004 000 727
- US-A1- 2005 045 903
- US-A1- 2005 151 149

## Beschreibung

Es wird ein Verfahren zur Herstellung eines oberflächenmontierbaren optoelektronischen Bauelements angegeben. Die Druckschriften US 4,843,280, JP 2000-077725 A, WO 2005/064696 A, US 2004/000727 A1, US 2005/045903 A1, US 2005/0151149 A1, JP 11-307675 A, EP 1 126 668 A2, WO 02/084749 A2, US 2002/030268 A1 und US 2002/005573 A1 beschreiben optoelektronische Bauelemente sowie Verfahren zur Herstellung dieser.

Eine Aufgabe besteht darin, ein Verfahren zur Herstellung eines oberflächenmontierbaren optoelektronischen Bauelements anzugeben, bei dem das Verhältnis von Gehäusevolumen zu Chipvolumen möglichst klein ist.

Gemäß zumindest einer Ausführungsform des oberflächenmontierbaren Bauelements, weist das oberflächenmontierbare Bauelement einen optoelektronischen Halbleiterchip auf. Bei dem optoelektronischen Halbleiterchip kann es sich um einen strahlungsempfangenden oder um einen strahlungsemittierenden Halbleiterchip handeln. Beispielsweise handelt es sich bei dem Halbleiterchip um einen Lumineszenzdiodenchip wie etwa einen Leuchtdiodenchip oder einen Laserdiodenchip. Weiter ist es möglich, dass es sich bei dem optoelektronischen Halbleiterchip um einen Fotodiodenchip handelt. Ferner kann das optoelektronische Bauelement mehrerer solcher Halbleiterchips umfassen. Das optoelektronische Bauelement kann dabei insbesondere auch einen strahlungsempfangenden und einen strahlungserzeugenden Halbleiterchip umfassen. Weiter ist es möglich, dass das optoelektronische Bauelement Lumineszenzdiodenchips umfasst, die geeignet sind elektromagnetische Strahlung von untereinander verschiedener Wellenlänge zu erzeugen.

Gemäß zumindest einer Ausführungsform des optoelektronischen Bauelements weist das optoelektronische Bauelement einen Formkörper auf. Bevorzugt ist der Formkörper zumindest stellenweise an den optoelektronischen Halbleiterchip angeformt. Das heißt, das Material des Formkörpers - die Formmasse - steht in Kontakt mit dem Halbleiterchip. Besonders bevorzugt umhüllt der Formkörper den Halbleiterchip zumindest stellenweise formschlüssig. Der Formkörper besteht dabei aus einem Material, das zumindest für einen Teil der elektromagnetischen Strahlung, die vom optoelektronischen Halbleiterchip im Betrieb des Bauelements emittiert wird oder von diesem empfangen werden soll, durchlässig ist. Bevorzugt handelt es sich bei dem Formkörper um einen Kunststoffformkörper, der einen Kunststoff enthält oder aus einem solchen besteht. Der optoelektronische Halbleiterchip ist bevorzugt mit der Formmasse des Formkörpers umgossen oder umspritzt. Das heißt, der Formkörper ist bevorzugt mittels eines Guss- oder Pressverfahrens hergestellt. Der Formkörper stellt dabei zugleich einen Verguss des Halbleiterchips und ein Gehäuse für das Bauelement dar.

Gemäß zumindest einer Ausführungsform des oberflächenmontierbaren Bauelements weist das Bauelement eine Montagefläche auf, die durch einen Teil der Oberfläche des Formkörpers gegeben ist. Die Montagefläche des Bauelements bezeichnet dabei jene Fläche des Bauelements, die einem Träger - beispielsweise einer Leiterplatte - auf die das oberflächenmontierbare Bauelement montiert ist, zugewandt ist. Die Montagefläche kann dabei eine tragende Fläche sein, mit der das Bauelement auf dem Träger aufliegt. Dazu kann die Montagefläche zumindest stellenweise mit dem Träger in mechanischem Kontakt stehen. Weiter ist es möglich, dass sich die Montagefläche mit einem Anschlussmaterial - beispielsweise einem Lot, über das das oberflächenmontierbare Bauelement elektrisch kontaktiert ist, in Kontakt befindet. Das heißt, das Anschlussmaterial benetzt dann Teile der Montagefläche und damit Teile des Formkörpers.

Gemäß zumindest einer Ausführungsform des oberflächenmontierbaren Bauelements weist das oberflächenmontierbare Bauelement zumindest eine Anschlussstelle auf.

Die Anschlussstellen des oberflächenmontierbaren Bauelements sind dabei zur elektrischen Kontaktierung des Bauelements vorgesehen. Sie befinden sich bevorzugt zumindest teilweise im Formkörper. Die Anschlussstellen sind an der Montagefläche des oberflächenmontierbaren Bauelements von außen zugänglich. Das heißt, an der Montagefläche des oberflächenmontierbaren Bauelements ist das Bauelement elektrisch kontaktierbar.

Gemäß zumindest einer Ausführungsform weist das Bauelement ferner Seitenflächen auf, die mittels eines Vereinzelns hergestellt sind. Die Seitenflächen sind diejenigen Flächen des Bauelements, die die Montagefläche seitlich umschließen und beispielsweise in einer Richtung quer zur Montagefläche verlaufen.

Die Seitenwände sind bevorzugt mittels Vereinzeln erzeugt. Insbesondere sind Kontur und Form der Seitenwände also nicht durch eine Guss- oder Pressprozess erzeugt, sondern mittels eines Vereinzelungsprozesses des Formkörpers. Das Vereinzeln kann beispielsweise mittels Sägen, Schneiden oder Herstellen einer Bruchkante und anschließendes Brechen erfolgen. Das heißt, beim Vereinzeln zu einzelnen Bauelementen findet bevorzugt ein Materialabtrag statt. Die Seitenflächen des Formkörpers und damit die Seitenflächen des Bauelements sind dann mittels eines Materialabtrags erzeugt. Die Seitenflächen weißen dann bevorzugt Spuren eines Materialabtrags auf. Wird bei der Herstellung des oberflächenmontierbaren Bauelements sowohl durch den Formkörper als auch durch die Anschlussstellen vereinzelt, das heißt, wird beispielsweise auch durch die Anschlussstellen gesägt, geschnitten oder gebrochen, so schließen die Anschlussstellen an den Seitenflächen, das heißt, lateral bündig mit dem Formkörper ab.

Mit anderen Worten werden die Anschlussstellen bevorzugt lateral vom Formkörper überragt oder schließen lateral bündig mit dem Formkörper ab. Lateral bezeichnet dabei diejenigen Richtungen, die in einer Ebene verlaufen, die sich parallel oder im Wesentlichen parallel zur Montagefläche erstreckt. Das heißt, die Anschlussstellen befinden sich an der Montagefläche des Bauelements und ragen nicht über die Seitenflächen des oberflächenmontierbaren Bauelements hinaus. Die Seitenflächen können zum Beispiel eben ausgebildet sein. Mit anderen Worten sind die Seitenflächen in diesem Fall vorsprungsfrei ausgebildet. Dies ist vor allem deshalb möglich, weil die Seitenflächen durch Vereinzeln erzeugt sind und die Anschlussstellen daher vom Formkörper überragt werden oder bündig mit diesem abschließen und dadurch die Anschlussstellen die Seitenflächen nicht durchstoßen oder aus ihnen hervorragen können.

An der Montagefläche des oberflächenmontierbaren Bauelements sind sowohl die Anschlussstellen als auch ein Teil des Formkörpers frei zugänglich.

Gemäß zumindest einer Ausführungsform des oberflächenmontierbaren optoelektronischen Bauelements weist das Bauelement einen optoelektronischen Halbleiterchip, einen Formkörper, der an den Halbleiterchip angeformt ist, eine Montagefläche, die zumindest stellenweise durch eine Oberfläche des Formkörpers gebildet ist, zumindest eine Anschlussstelle, sowie Seitenflächen auf, die durch Vereinzeln erzeugt sind.

Das oberflächenmontierbare Bauelement macht sich dabei unter anderem die Idee zunutze, dass ein Formkörper, der als Verguss und Gehäuse für einen oberflächenmontierbaren optoelektronischen Chip dient, ein Bauelement ermöglicht, das einen besonders kleinen Formfaktor aufweist. Das heißt, das Verhältnis von Gehäusevolumen zu Chipvolumen ist bei diesem Bauelement besonders klein. Sind zudem noch die elektrischen Anschlussstellen des Bauelements derart angeordnet, dass sie lateral höchstens mit dem Formkörper abschließen, und diesen lateral bündig nicht überragen - das heißt, sind Seitenflächen des Bauelements durch einen Vereinzelungsprozess erzeugt, so ergibt sich ein besonders kompaktes oberflächenmontierbares optoelektronisches Bauelement. Solch ein Bauelement eignet sich beispielsweise besonders gut für den Einsatz als Lumineszenzdiode oder optischer Detektor in besonders kleinen Geräten wie Handys, Fotohandys oder Digitalbildkameras. Bei diesen Geräten ist nur sehr begrenzt Raum für die Montage optoelektronischer Komponenten vorhanden.

Gemäß der Erfindung ist der Formkörper an die Anschlussstellen des Bauelements angeformt. Das heißt, der Formkörper fasst die Anschlussstellen des Bauelements zumindest stellenweise formschlüssig ein. Die Anschlussstellen weisen dabei jeweils eine Fläche auf, über die sie von außerhalb des Bauelements elektrisch kontaktierbar sind. Das heißt, zumindest an der Anschlussfläche ist die Anschlussstelle dann nicht vom Formkörper eingefasst.

Gemäß der Erfindung weisen die Anschlussstellen des Bauelements eine Verankerungsstruktur auf, die geeignet ist, eine Haftung des Formkörpers an die Anschlussstellen zu verbessern.

Gemäß der Erfindung weisen die Anschlussstellen des Bauelements eine pilzförmige Struktur auf. Dabei ist die Kappe der pilzförmig ausgebildeten Anschlussstelle bevorzugt auf der der Montagefläche des Bauelements abgewandten Seite der Anschlussstelle angeordnet. Eine solche pilzförmig ausgebildete Anschlussstelle kann vor allem ein Ablösen der Vergussmasse in Richtung von der Montagefläche weggerichtet hemmen oder verhindern. Beispielsweise kann eine solche pilzförmige Anschlussstelle durch Unterätzen oder Unterschneiden einer metallischen Anschlussstelle erzeugt sein.

Gemäß der Erfindung weist zumindest eine der Anschlussstellen des oberflächenmontierbaren Bauelements eine Montagefläche auf, auf die der optoelektronische Halbleiterchip befestigt ist. Die Montagefläche der Anschlussstelle ist dabei bevorzugt durch eine der Montagefläche des optoelektronischen Halbleiterchips abgewandte Fläche der Anschlussstelle gebildet. Der Chip kann beispielsweise leitend mit der Montagefläche der Anschlussstelle verbunden sein. Der Chip ist auf die Montagefläche gebondet, gelötet oder elektrisch leitend geklebt. Ein zweiter elektrischer Kontakt des optoelektronischen Halbleiterchips ist dann zum Beispiel durch eine Drahtkontaktierung gegeben, wobei ein Draht mit einer weiteren Anschlussstelle des Bauelements verbunden sein kann.

Darüber hinaus ist es auch möglich, dass der optoelektronische Halbleiterchip auf die Montageflächen zweier unterschiedlicher Anschlussstellen in so genanter Flip-Chip-Technik aufgebracht ist. Eine Drahtkontaktierung kann in dieser Ausführungsform entfallen.

Gemäß zumindest einer Ausführungsform des oberflächenmontierbaren Bauelements weist zumindest eine der Anschlussstellen des Bauelements eine Montagefläche auf, auf die ein ESD (electro static discharge) Schutzelement aufgebracht ist. Dabei kann es sich um diejenige Anschlussstelle handeln, auf die auch der Chip schon aufgebracht ist. Bevorzugt ist das ESD-Schutzelement jedoch auf eine weitere Anschlussstelle aufgebracht. Das ESD-Schutzelement ist geeignet, Spannungsspitzen, die beispielsweise in Sperrrichtung des optoelektronischen Halbleiterchips auftreten, abzuleiten. Bei dem ESD-Schutzelement handelt es sich beispielsweise um eines der folgenden Komponenten: Varistor, Leuchtdiodenchip, Zenerdiode, Widerstand. Das ESD-Schutzelement ist dabei parallel beziehungsweise antiparallel zum optoelektronischen Halbleiterchip verschaltet.

Handelt es sich bei dem ESD-Schutzelement etwa um einen Leuchtdiodenchip, so ist dieser antiparallel zum optoelektronischen Halbleiterchip verschaltet. Dieser Leuchtdiodenchip kann dann ebenfalls zur Strahlungserzeugung genutzt werden.

Gemäß der Erfindung weist zumindest eine der Anschlussstellen des Bauelements eine Anschlussfläche auf, über die der Halbleiterchip elektrisch kontaktiert werden kann. Die Anschlussfläche ist von außerhalb des Bauelements elektrisch kontaktierbar. Beispielsweise ist die Anschlussfläche durch die Fläche der Anschlussstelle gegeben, die der Montagefläche des Bauelements zugewandt ist. Die Anschlussfläche der Anschlussstelle ist dann zum Beispiel einer Montagefläche der Anschlussstelle abgewandt. Die Anschlussstelle ist an der Montagefläche des Bauelements frei zugänglich und dort elektrisch kontaktierbar. Besonders bevorzugt weist jede Anschlussstelle des Bauelements eine solche Anschlussfläche auf.

Gemäß zumindest einer Ausführungsform des oberflächenmontierbaren Bauelements schließt die Anschlussfläche zumindest einer Anschlussstelle des Bauelements bündig mit der Montagefläche des Bauelements ab. Das heißt, die Anschlussstelle überragt die Montagestelle nicht. Mit anderen Worten ist die Montagefläche im Bereich der Anschlussstelle durch die Anschlussfläche der Anschlussstelle gebildet. Eine solche Ausführungsform der Anschlussfläche resultiert zu einem besonders kompakten oberflächenmontierbaren Bauelement bei dem die äußere Form lediglich durch den Formkörper bestimmt ist, und keine weiteren Komponenten aus diesem hervorragen.

Gemäß zumindest einer Ausführungsform des oberflächenmontierbaren Bauelements ist die Anschlussfläche zumindest einer der Anschlussstellen des Bauelements in einer Ausnehmung der Montagefläche angeordnet. Das heißt, die Montagefläche weist beispielsweise ein Loch auf, über das die Anschlussfläche zugänglich ist. Die Anschlussfläche befindet sich in dieser Ausführungsform vollständig im Formkörper. Ein Anschlussmaterial - beispielsweise eine Lot - kann etwa durch Kapillarkräfte in die Ausnehmung der Montagefläche gezogen werden und kontaktiert auf diese Weise das oberflächenmontierbare Bauelement an der Anschlussfläche.

Weiter ist es möglich, dass die Anschlussfläche derart mit einem Anschlussmaterial beschichtet ist, dass das Anschlussmaterial bündig mit der Montagefläche des Bauelements abschließt oder diese geringfügig überragt. Diese Bauform des oberflächenmontierbaren Bauelements resultiert in einer besonders flachen Montage des Bauelements. Das Bauelement kann mit seiner Montagefläche direkt auf einem Träger aufliegen, wobei sich kein oder kaum Anschlussmaterial zwischen Träger und Montagefläche befindet.

Gemäß zumindest einer Ausführungsform des oberflächenmontierbaren Bauelements ist zumindest eine Anschlussfläche des Bauelements zumindest stellenweise mit einem Material beschichtet, das geeignet ist, die Haftung an den Formkörper zu verbessern. Dabei sind bevorzugt nur Bereiche der Anschlussstellen beschichtet, die sich in Kontakt mit dem Formkörper befinden. Insbesondere die Anschlussfläche der Anschlussstelle bleibt vorzugsweise von dem Material frei. Besonders bevorzugt sind alle Anschlussstellen des Bauelements mit dem Material beschichtet.

Gemäß zumindest einer Ausführungsform des oberflächenmontierbaren Bauelements ist der optoelektronische Halbleiterchip zumindest stellenweise mit dem Material beschichtet, das geeignet ist, die Haftung an den Formkörper zu verbessern.

Gemäß zumindest einer Ausführungsform des oberflächenmontierbaren Bauelements ist das ESD-Schutzelement, das dem optoelektronischen Halbleiterchip parallel oder antiparallel geschaltet ist, zumindest stellenweise mit dem Material beschichtet, das geeignet ist, die Haftung an den Formkörper zu verbessern.

Gemäß zumindest einer Ausführungsform des oberflächenmontierbaren Bauelements ist ein Kontaktierungsdraht, der zur elektrischen Kontaktierung des optoelektronischen Halbleiterchips vorgesehen ist, zumindest stellenweise mit dem Material beschichtet, das geeignet ist, die Haftung an den Formkörper zu verbessern.

Bevorzugt sind alle Kontaktierungsdrähte des Bauelements in dieser Weise mit dem Material beschichtet.

Gemäß zumindest einer Ausführungsform des oberflächenmontierbaren Bauelements sind alle Komponenten des Bauelements, die sich innerhalb des Formkörpers befinden, zumindest stellenweise mit dem Material beschichtet, das geeignet ist, eine Haftung zwischen den Komponenten des Bauelements und dem Formkörper zu verbessern.

Gemäß zumindest einer Ausführungsform des oberflächenmontierbaren Bauelements enthält das Material, das zur Verbesserung der Haftung an den Formkörper geeignet ist, ein Silikat. Bevorzugt wird die Silikatschicht vor dem Vergießen oder Umspritzen des Bauelements mit dem Formkörper aufgebracht. Beispielsweise wird die Silikatschicht mittels Flammenpyrolyse aufgebracht. Auf diese Weise ist es möglich, eine Schicht aufzubringen, die maximal 40 Nanometer, bevorzugt maximal 20 Nanometer, besonders bevorzugt maximal 5 Nanometer dick ist. Bei einer auf diese Weise aufgebrachten Silikatbeschichtung handelt es sich dann um eine extrem dünne, sehr dichte, festhaltende Schicht, die eine große Oberflächenenergie aufweist und daher geeignet ist, die Haftung des Formkörpers an die Komponenten des Bauelements wie Anschlussstellen, Chip, ESD-Schutzelement und Kontaktierungsdrähte zu verbessern.

Zumindest in einer Ausführungsform des oberflächenmontierbaren Bauelements enthält der Formkörper ein Silikon. Bevorzugt enthält der Formkörper eine reaktionshärtende Silikonformmasse oder besteht aus einer solchen.

Gemäß zumindest einer Ausführungsform des oberflächenmontierbaren Bauelements enthält der Formkörper ein Epoxidharz oder besteht aus einem solchen.

Gemäß zumindest einer Ausführungsform des oberflächenmontierbaren Bauelements enthält der Formkörper ein Epoxid-Silikon-Hybridmaterial oder besteht aus einem solchen. Bei Formmassen, die neben einem Epoxidharz auch ein Silikon enthalten, ist die.Alterungsstabilität des Formkörpers verbessert. Der Formkörper ist dann beispielsweise besonders stabil gegen ultraviolette Strahlung. Weiter kann die Formmasse beispielsweise mittels des Mischverhältnisses von Silikon und Epoxidharz an die Anforderungen des Bauelements und des Herstellungsprozesses angepasst sein. So härten Epoxid-Silikon-Hybridmaterialien in der Regel schneller aus, als reine Silikonformmassen und zeichnen sich durch eine verbesserte mechanische Stabilität aus. Ein Formkörper aus diesem Material lässt sich daher leichter aus einem Guss- oder Presswerkzeug entfernen. Zudem sind kürzere Prozesszeiten möglich, was eine kostengünstigere Herstellung des Bauelements ermöglicht. Besonders vorteilhaft erweist sich dabei zum Beispiel eine Formmasse, die circa 50 Prozent Silikon und circa 50 Prozent Epoxidharz enthält.

Das hier beschriebene oberflächenmontierbare Bauelement macht sich dabei unter anderem die Erkenntnis zunutze, dass mittels pilzförmiger Anschlussstellen, einer Beschichtung der Komponenten mit einem Material, das die Haftung zwischen Formkörper und Komponenten des Bauelements verbessert und einer Formmasse, die ein Silikon enthält ein mechanisch besonders stabiles Bauelement erreicht ist. Die Kombination der beschriebenen Maßnahmen ergibt ein Bauelement mit sehr geringer Delaminierungsneigung, hoher mechanischer Stabilität und verbesserten Alterungseigenschaften. Durch die Anordnung der Anschlussstellen des Bauelements an der Montagefläche ist zudem eine sehr kompakte Bauform realisiert.

Gemäß zumindest einer Ausführungsform des oberflächenmontierbaren Bauelements enthält der Formkörper Diffuserpartikel. Bei den Diffuserpartikeln handelt es sich um Partikel, die geeignet sind vom optoelektronischen Halbleiterchip zu emittierende oder zu empfangende elektromagnetische Strahlung zu streuen.

Gemäß zumindest einer Ausführungsform des oberflächenmontierbaren Bauelements enthält der Formkörper strahlungsabsorbierende Partikel, die geeignet sind, elektromagnetische Strahlung eines bestimmten Wellenlängenbereichs zu absorbieren. Solche Partikel können im Bauelement als Filter eingesetzt werden. Handelt es sich bei dem optoelektronischen Halbleiterchip beispielsweise um einen Detektor, ist auf diese Weise ein Detektor realisiert, der in einem bestimmten Wellenlängenbereich eine besonders große Empfindlichkeit aufweist.

Gemäß zumindest einer Ausführungsform des oberflächenmontierbaren Bauelements enthält der Formkörper Glasfasern. Die Glasfasern können beispielsweise die mechanische Stabilität des Formkörpers weiter verbessern.

Gemäß zumindest einer Ausführungsform des oberflächenmontierbaren Bauelements enthält der Formkörper ein Formtrennmittel. Das Formtrennmittel kann sich bei der Herstellung des Bauelements als besonders vorteilhaft erweisen, da unter Verwendung des Formtrennmittels das Ablösen des Formkörpers aus dem Guss- oder Presswerkzeug erleichtert ist.

Gemäß zumindest einer Ausführungsform enthält der Formkörper ein Lumineszenzkonversionsmaterial. Das Lumineszenzkonversionsmaterial ist bevorzugt geeignet, zumindest einen Teil einer vom optoelektronischen Halbleiterchip im Betrieb emittierten und/oder vom Halbleiterchip zu empfangenen elektromagnetischen Strahlung eines ersten Wellenlängenbereichs zu absorbieren und elektromagnetische Strahlung zu emittieren, die aus einem zweiten Wellenlängenbereich stammt, der vom ersten Wellenlängenbereich verschieden ist. Insbesondere anorganische Leuchtstoffpulver lassen sich auf besonders einfache Weise in silikonhaltige Formmassen einmischen. Beispielhaft seien diesbezüglich Cer-dotierte Yttriumaluminiumgranat- und Cer-dotierte Terbiumaluminiumgranatpulver genannt. Geeignete organische und anorganische Leuchtstoffe sind beispielsweise in den Druckschriften WO 01/50540A1 und WO 98/12757A1 aufgeführt, deren Offenbarungsgehalt die Leuchtstoffe betreffend hiermit durch Rückbezug aufgenommen ist.

Gemäß zumindest einer Ausführungsform des oberflächenmontierbaren Bauelements weist der Formkörper eine weitere innere Schicht auf. Die innere Schicht des Formkörpers ist an den optoelektronischen Halbleiterchip angeformt. Das heißt, die innere Schicht fasst den optoelektronischen Halbleiterchip ein. Ferner weist der Formkörper eine äußere Schicht auf, die vom Halbleiterchip entfernt liegt und beispielsweise durch die der Montagefläche abgewandten Oberfläche des Formkörpers begrenzt ist. Zwischen der äußeren und der inneren Schicht befindet sich dann eine Schicht, die ein Lumineszenzkonversionsmaterial enthält. Das heißt, die Leuchtstoffpartikel des Lumineszenzkonversionsmaterials sind in einer Schicht über dem optoelektronischen Halbleiterchip angeordnet. Bevorzugt sind die innere und die äußere Schicht dabei frei von einem Lumineszenzkonversionsmaterial. Diese Schichten können jedoch andere Materialien wie beispielsweise lichtstreuende Partikel enthalten.

Gemäß zumindest einer Ausführungsform des oberflächenmontierbaren Bauelements weist der Formkörper des Bauelements eine linsenartig ausgebildete Strahlungsdurchtrittsfläche auf. Die Strahlungsdurchtrittsfläche ist dabei beispielsweise durch die der Montagefläche abgewandte Oberfläche des Formkörpers gebildet. Linsenartig ausgebildet kann dabei heißen, dass die Strahlungsdurchtrittsfläche eine Krümmung aufweist. Zum Beispiel kann die Strahlungsdurchtrittsfläche konvex nach außen gewölbt sein. Die Strahlungsdurchtrittsfläche kann dann nach Art eines sphärischen, einer elliptischen oder einer asphärischen Linse gewölbt sein. Die Krümmung der Strahlungsdurchtrittsfläche kann zum einen zur Strahlformung aus dem Bauelement austretender oder in das Bauelement eintretender elektromagnetischer Strahlung dienen. Zum anderen ist es möglich, dass sich aufgrund der Krümmung der Strahlungsdurchtrittsfläche die Wahrscheinlichkeit für den Lichtaustritt aus dem Formkörper erhöht. Dies ist dadurch begründet, dass beispielsweise eine sphärische Krümmung der Strahlungsdurchtrittsfläche die Wahrscheinlichkeit für Totalreflexion von elektromagnetischer Strahlung beim Austritt aus dem Formkörper reduziert.

Ferner wird ein Verfahren zur Herstellung eines oberflächenmontierbaren optoelektronischen Bauelements angegeben. Beispielsweise kann mittels des Verfahrens ein Bauelement nach einem der vorherigen Ausführungsformen hergestellt werden.

Gemäß der Erfindung wird zunächst eine Vielzahl von optoelektronischen Halbleiterchips in der Kavität eines Press- oder Gusswerkzeuges angeordnet. Die optoelektronischen Halbleiterchips sind dabei schon auf Anschlussstellen aufgebracht und elektrisch zum Beispiel mittels Anschlussdrähte kontaktiert. Die Anschlussstellen sind auf einem gemeinsamen Substrat aufgebracht. Anschließend werden die Halbleiterchips mit einem gemeinsamen Formkörper umhüllt. Das heißt, die optoelektronischen Halbleiterchips werden zusammen mit den anderen Komponenten des Bauelements gemeinsam in der Kavität vergossen oder umspritzt. Auf diese Weise entsteht ein Block mit einer Vielzahl von optoelektronischen Halbleiterchips, die von einer gemeinsamen Formmasse umgeben sind. Nach dem Aushärten der Formmasse bildet die Formmasse einen Formkörper, der an die optoelektronischen Halbleiterchips angeformt ist.

In einem folgenden Verfahrensschritt wird der gemeinsame Formkörper dann zur Vereinzelung der Bauelemente durchtrennt. Dabei ist es nicht zwingend erforderlich, dass Bauelemente mit jeweils nur einem einzigen optoelektronischen Halbleiterchip erzeugt werden. Es ist zum Beispiel auch möglich, dass mehrere optoelektronische Halbleiterchips in einem einzelnen Bauelement zusammengefasst sind. Dabei kann es sich insbesondere auch um unterschiedliche optoelektronische Halbleiterchips handeln wie beispielsweise Lumineszenzdioden unterschiedlicher Emissionswellenlänge oder Lumineszenzdiodenchips und Fotodiodenchips.

Gemäß der Erfindung wird zum Vereinzeln des Bauelements ausschließlich der Formkörper durchtrennt. Das heißt, zur Vereinzelung des Bauelements wird nicht durch die Anschlussstellen des Bauelements vereinzelt. In diesem Fall sind die Anschlussstellen allseitig vom Formkörper umgeben und nur an ihren Anschlussflächen an der Montagefläche des Bauelements zugänglich. Der Formkörper überragt dann die Anschlussstellen in lateraler Richtung.

Gemäß zumindest einer Ausführungsform des Verfahrens zur Herstellung eines oberflächenmontierbaren Bauelements erfolgt das Vereinzeln mittels Sägen oder Schneidens.

Gemäß zumindest einer Ausführungsform enthält die Formmasse die nach dem Aushärten den Formkörper bildet, zumindest eines der folgenden Materialen: Epoxid, Silikon, Epoxid-Silikon-Hybridmaterial. Bevorzugt sind diese Materialien dabei reaktionshärtend. Die Formmasse kann dabei vor dem Umgießen oder Umspritzen in flüssiger oder pastoröser Form vorliegen. Besonders bevorzugt handelt es sich bei der Formmasse um ein vorreagiertes Material, das vor dem Weiterverarbeiten in Festform vorliegt. Dies erweist sich insbesondere auch für Epoxid-Silikon-Hybridmaterialien als besonders vorteilhaft für die Weiterverarbeitung.

Das hier beschriebene Verfahren macht sich dabei unter anderem die folgende Erkenntnis zunutze. Insbesondere Formmassen, die ein Silikon enthalten, weisen bei der Verarbeitung in einem Guss- oder Presswerkzeug eine besonders niedrige Viskosität auf. Diese niedrige Viskosität führt beim Vergießen von Bauelementen in Einzelkavitäten zu vermehrter Grat- oder Flash-Bildung. Dickenschwankungen und Schwankungen der Oberflächenrauhigkeit beispielsweise eines Substrats, auf dem sich die Anschlussstellen befinden, können beim Umhüllen in Einzelkavitäten nur schwer ausgeglichen werden. Es hat sich aber gezeigt, dass diese Schwierigkeiten bei der Verwendung silikonhaltiger Formmassen durch ein Umgießen von mehreren optoelektronischen Bauelementen in einer einzigen Kavität vermieden werden können.

Gemäß zumindest einer Ausführungsform des hier beschriebenen Verfahrens werden die Komponenten des Bauelements vor dem Umhüllen mit der Formmasse mit einem Material beschichtet, das geeignet ist, die Haftung zum Formkörper zu erhöhen. Bei dem Material handelt es sich vorzugsweise um ein Silikat. Das Material kann dabei mittels Flammenpyrolyse auf die Komponenten des Bauelements aufgebracht werden. Auf diese Weise entsteht eine maximal 40 Nanometer, bevorzugt maximal 20 Nanometer, besonders bevorzugt maximal 5 Nanometer dicke Schicht aus Silikat, die zumindest Teile der Komponenten des Bauelements umhüllt und eine besonders gute Haftung zur Formmasse vermittelt.

Im Folgenden werden die hier beschriebene Leuchtdiodenanordnung sowie weitere Bauelemente anhand von Ausführungsbeispielen und Beispielen und den dazugehörigen Figuren näher erläutert.
Figur 1a zeigt eine schematische Schnittdarstellung eines Ausführungsbeispiels des hier beschriebenen oberflächenmontierbaren Bauelements.
Figur 1b zeigt eine schematische Schnittdarstellung eines Beispiels eines oberflächenmontierbaren Bauelements.
Figur 1c zeigt eine schematische Aufsicht auf die Montagefläche eines weiteren Ausführungsbeispiels des hier beschriebenen oberflächenmontierbaren Bauelements.
Figur 2a zeigt eine schematische Schnittdarstellung eines weiteren Ausführungsbeispiels des hier beschriebenen oberflächenmontierbaren Bauelements.
Figur 2b zeigt eine schematische Schnittdarstellung eines Beispiels eines oberflächenmontierbaren Bauelements.
Figur 3a zeigt eine schematische Schnittdarstellung eines Beispiels eines oberflächenmontierbaren Bauelements.
Figur 3b zeigt eine schematische Schnittdarstellung eines Beispiels eines oberflächenmontierbaren Bauelements.
Figur 4 zeigt eine schematische Schnittdarstellung eines weiteren Ausführungsbeispiels des hier beschriebenen oberflächenmontierbaren Bauelements.
Figur 5 zeigt eine schematische Schnittdarstellung eines weiteren Ausführungsbeispiels des hier beschriebenen oberflächenmontierbaren Bauelements.
Figur 6 zeigt eine schematische Schnittdarstellung eines weiteren Ausführungsbeispiels des hier beschriebenen oberflächenmontierbaren Bauelements.
Figur 7 zeigt eine schematische Schnittdarstellung eines weiteren Ausführungsbeispiels des hier beschriebenen oberflächenmontierbaren Bauelements.
Figur 8 zeigt eine schematische Schnittdarstellung eines weiteren Ausführungsbeispiels des hier beschriebenen oberflächenmontierbaren Bauelements.
Figuren 9a, 9b, 9c, 9d, 9e, 9f und 9g zeigen schematische Schnittdarstellungen zur Erläuterung eines Ausführungsbeispiels des hier beschriebenen Verfahrens.
Figur 10 zeigt eine schematische Schnittdarstellung eines mittels eines anderen Verfahrens hergestellten oberflächenmontierbaren Bauelements.
Figur 11a zeigt eine schematische Draufsicht eines weiteren Ausführungsbeispiels des hier beschriebenen oberflächenmontierbaren Bauelements.
Figur 11b zeigt eine schematische Schnittdarstellung entlang der Linie A-A' des in Verbindung mit der Figur 11a beschriebenen oberflächenmontierbaren Bauelements.

In den Ausführungsbeispielen und Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

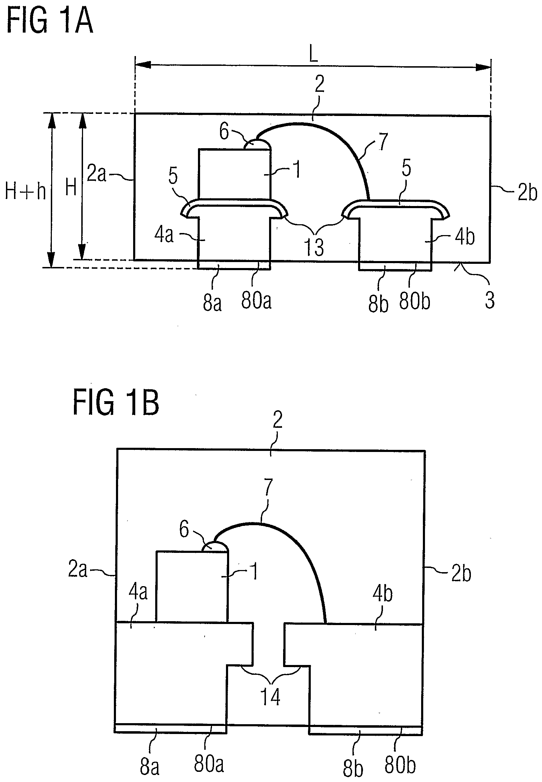

Figur 1a zeigt eine schematische Schnittdarstellung eines Ausführungsbeispiels des hier beschriebenen oberflächenmontierbaren Bauelements.

Das oberflächenmontierbare optoelektronische Bauelement weist einen optoelektronischen Halbleiterchip 1 auf. Bei dem optoelektronischen Halbleiterchip 1 handelt es sich beispielsweise um einen Lumineszenzdiodenchip - etwa um einen Laserdiodenchip oder einen Leuchtdiodenchip. Es kann sich beim optoelektronischen Halbleiterchip 1 aber auch um einen Detektorchip wie beispielsweise eine Fotodiode handeln. Beispielsweise handelt es sich bei dem Halbleiterchip 1 dann um einen Si-Fotodiodenchip.

Bevorzugt handelt es sich bei dem optoelektronischen Chip 1 um ein in Dünnfilmtechnik hergestelltes optoelektronisches Halbleiterbauelement. Das heißt, in wenigstens einem Ausführungsbeispiel weist der Halbleiterchip 1 eine Strahlungsauskoppelfläche auf, durch die ein Großteil der vom Halbleiterchip 1 emittierten elektromagnetischen Strahlung ausgekoppelt wird. Besonders bevorzugt tritt die gesamte vom Halbleiterchip 1 emittierte Strahlung durch die Strahlungsauskoppelfläche aus. Die Strahlungsauskoppelfläche ist beispielsweise durch einen Teil der Oberfläche des Halbleiterchips 1 gegeben. Bevorzugt ist die Strahlungsauskoppelfläche durch eine Hauptfläche des Halbleiterchips 1 gegeben, die beispielsweise parallel zu einer Epitaxieschichtenfolge des Halbleiterchips 1 angeordnet ist, welche geeignet ist, elektromagnetische Strahlung zu erzeugen.

Dazu kann die Epitaxieschichtenfolge beispielsweise einen pn-Übergang, eine Doppelheterostruktur, einen Einfach-Quantentopf oder besonders bevorzugt eine Mehrfach-Quantentopfstruktur (MQW) aufweisen. Die Bezeichnung Quantentopfstruktur umfasst im Rahmen der Offenbarung insbesondere jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit unter Anderem Quantentröge, Quantendrähte und Quantenpunkte und jede Kombination dieser Strukturen.

Bevorzugt handelt es sich bei dem Halbleiterchip 1 um einen Halbleiterchip bei dem das Aufwachssubstrat zumindest teilweise entfernt ist und auf dessen dem ursprünglichen Aufwachssubstrat abgewandte Oberfläche ein Trägerelement aufgebracht ist.

Das Trägerelement kann, verglichen mit einem Aufwachssubstrat, relativ frei gewählt werden. Bevorzugt wird ein Trägerelement gewählt, das hinsichtlich seines Temperaturausdehnungskoeffizienten besonders gut an die strahlungserzeugende Epitaxieschichtenfolge angepasst ist. Weiter kann das Trägerelement ein Material enthalten, das besonders gut Wärme leitend ist. Auf diese Weise wird die im Betrieb vom Halbleiterchip 1 erzeugte Wärme besonders effizient an die Anschlussstelle 4a abgeführt.

Solche, durch das Entfernen des Aufwachssubstrats hergestellten Halbleiterchips 1, werden oftmals als Dünnfilmhalbleiterchips bezeichnet und zeichnen sich bevorzugt durch die folgenden Merkmale aus:
- An einer zum Trägerelement hingewandten ersten Hauptfläche der strahlungserzeugenden Epitaxieschichtenfolge ist eine reflektierende Schicht oder Schichtenfolge aufgebracht oder ausgebildet, die zumindest einen Teil der in der Epitaxieschichtenfolge erzeugten elektromagnetischen Strahlung in diese zurückreflektiert.
- Die Epitaxieschichtenfolge weist bevorzugt eine Dicke von maximal 20 *µ*m, besonders bevorzugt von maximal 10 *µ*m auf.
- Weiter enthält die Epitaxieschichtenfolge bevorzugt mindestens eine Halbleiterschicht mit zumindest einer Fläche, die eine Durchmischungsstruktur aufweist. Im Idealfall führt diese Durchmischungsstruktur zu einer annähernd ergodischen Verteilung des Lichts in der Epitaxieschichtenfolge, d.h. sie weist ein möglichst ergodisch, stochastisches Streuverhalten auf.

Ein Grundprinzip eines Dünnfilmhalbleiterchips ist beispielsweise in der Druckschrift I. Schnitzer at al., Appl. Phys. Lett. 63(16), 18. Oktober 1993, Seiten 2174 bis 2176 beschrieben, deren Offenbarungsgehalt das Grundprinzip eines Dünnfilmhalbleiterchips betreffend hiermit durch Rückbezug aufgenommen wird.

Ein solcher in Dünnfilmchip hergestellter optoelektronischer Halbleiterchip hat dabei unter anderem den Vorteil, dass er wegen seiner geringen Höhe ein oberflächenmontierbares Bauelement besonders geringer Bauhöhe ermöglicht.

Der optoelektronische Halbleiterchip 1 des Ausführungsbeispiels der Figur 1a ist auf eine Anschlussstelle 4a des Bauelements aufgebracht und mit dieser elektrischer kontaktiert. Beispielsweise ist der optoelektronische Halbleiterchip 1 auf die Anschlussstelle 4a gelötet, leitend geklebt oder gebondet. Die Anschlussstelle 4a kann dazu eine Beschichtung 5 aufweisen, die die Kontaktierbarkeit des Halbleiterchips an der Anschlussstelle 4a verbessert. Die Beschichtung 5 kann zum Beispiel Gold enthalten.

Die Anschlussstellen 4a, 4b des oberflächenmontierbaren Bauelements enthalten zum Beispiel Kupfer oder bestehen aus Kupfer. Sie sind bevorzugt durch eine Abfolge von Ätzschritten und galvanischen Beschichtungsschritten erzeugt. Die Anschlussstellen 4a, 4b weisen inklusive Beschichtung 5 bevorzugt eine Höhe von 30 bis 60 µm auf.

Die Anschlussstellen 4a, 4b des Ausführungsbeispiels der Figur 1a sind pilzförmig ausgebildet. Sie weisen eine Verankerungsstruktur 13 auf, die als Vorsprung oder Überhang ausgebildet ist. Die Länge des Vorsprungs beträgt dabei in lateraler Richtung, das heißt in Richtung parallel zur Montagefläche 3 des Bauelements, wenigstens 3 µm. Die Höhe der Anschlussstellen 4a und 4b bis zum Überhang beträgt wenigstens 20 µm. Der Abstand zwischen den beiden Anschlussstellen 4a und 4b des in Verbindung mit Figur 1a beschriebenen Ausführungsbeispiels des oberflächenmontierbaren Bauelements beträgt bevorzugt wenigstens 140 µm.

Der optoelektronische Halbleiterchip 1 ist im Ausführungsbeispiel der Figur 1a durch einen Kontaktierungsdraht 7 mit der zweiten Anschlussstelle 4b des Bauelements elektrisch leitend verbunden. Der Kontaktierungsdraht 7 ist beispielsweise durch einen Golddraht gegeben. Die zweite Anschlussstelle 4b kann zur Verbesserung der Kontaktierbarkeit des Kontaktierungsdrahtes 7 ebenfalls eine Beschichtung 5 aufweisen. Der Kontaktierungsdraht 7 ist zum Beispiel mittels eines Bondpads 6 auf der Oberseite des optoelektronischen Halbleiterchips 1 kontaktiert.

An die Komponenten des Bauelements wie den optoelektronischen Halbleiterchip 1, die Anschlussstellen 4a, 4b und den Kontaktierungsdraht 7 ist zumindest stellenweise ein Formkörper 2 angeformt. Der Formkörper 2 enthält bevorzugt zumindest eines der folgenden Materialien: Epoxidharz, Silikon, Epoxid-Silikon-Hybridmaterial. Bevorzugt enthält der Formkörper 2 ein Epoxid-Silikon-Hybridmaterial mit einem Anteil von circa 50 Prozent Silikon und circa 50 Prozent Epoxid. Dabei kann es sich um ein reaktionshärtendes Material handeln, das vor dem Anformen an die Komponenten des Bauelements vorreagiert worden ist. Der Formkörper 2 ist zumindest teilweise für vom optoelektronischen Halbleiterchip 1 auszusendende oder zu empfangende elektromagnetische Strahlung durchlässig. Das heißt, der Formkörper 2 ist zumindest in einem bestimmten Wellenlängenbereich für elektromagnetische Strahlung transparent oder transluzent.

Die Seitenflächen 2a, 2b des Bauelements sind nach dem Aushärten des Formkörpers 2 mittels Vereinzeln erzeugt. Das heißt, sie sind beispielsweise mittels Sägen, Schneidens oder Brechens erzeugt, wobei beim Brechen zunächst eine Sollbruchkante erzeugt wird. Die Seitenflächen 2a, 2b können also Spuren eines Materialabtrags aufweisen. Die Seitenflächen 2a, 2b des Bauelements sind daher im Wesentlichen eben oder glatt ausgebildet. Insbesondere sind die Seitenflächen 2a, 2b frei von makroskopischen Vorsprüngen. Das heißt es ragen beispielsweise keine Anschlussstellen des Bauelements aus den Seitenflächen 2a, 2b hervor. Der Formkörper überragt die Anschlussstellen 4a, 4b also in lateraler Richtung, das heißt in einer Richtung parallel zur Montagefläche 3 und quer zu den Seitenflächen 2a, 2b.

Die Unterseite des Formkörpers bildet zumindest einen Teil der Montagefläche 3 des Bauelements. Bei dem oberflächenmontierbaren Bauelement ist die Montagefläche 3 einem Bauelementträger (nicht gezeigt) zugewandt und kann sich zumindest stellenweise mit solch einem Bauelementträger in Kontakt befinden.

Auf die der Montagefläche 3 zugewandten Anschlussflächen 80a, 80b der Anschlussstellen 4a, 4b ist jeweils eine Lotschicht 8a, 8b aufgebracht. Die Lotschichten 8a, 8b sind zum Beispiel durch eine Nickel-Gold-Schichtfolge gegeben. Das Bauelement kann dann zum Beispiel durch einen Reflow-Lötprozess montierbar sein.

Die Länge L des Bauelements des Ausführungsbeispiels der Figur 1a beträgt bevorzugt zwischen 1,5 und 2,1 Millimeter, besonders bevorzugt circa 1,8 Millimeter. Die Gesamthöhe H plus h des Bauelements beträgt zwischen 0,5 und 0,9 Millimeter, bevorzugt 0,7 Millimeter. Dabei beträgt die Höhe H des Formkörpers wenigstens 0,3 Millimeter.

Figur 1b zeigt eine schematische Schnittdarstellung eines Beispiels eines oberflächenmontierbaren optoelektronischen Bauelements.

Abweichend vom Ausführungsbeispiel der Figur 1a sind die Anschlussstellen 4a, 4b in diesem Beispiel durch Teile eines Leiterrahmens gegeben. Der Leiterrahmen ist dabei durch wenigstens einen Ätzprozess strukturiert und weist Überhänge 14 auf, die zur Verankerung der Anschlussstellen 4a, 4b in der Formmasse 2 dienen. Ebenfalls im Unterschied zum Ausführungsbeispiel der Figur 1a sind die Seitenflächen 2a, 2b des Bauelements in diesem Beispiel stellenweise durch die Anschlussstellen 4a, 4b gebildet. Das heißt, im in Verbindung mit Figur 1b beschriebenen Ausführungsbeispiel des Bauelements schließt der Formkörper 2 lateral bündig mit den Anschlussstellen 4a, 4b ab. Lateral bezeichnet dabei diejenige Richtung, die quer zu den Seitenflächen 2a, 2b des Bauelements verläuft. Das heißt, die Anschlussstellen 4a, 4b überragen die Montagefläche 3 lateral nicht. Die Anschlussstellen 4a, 4b stehen nicht über die Seitenflächen 2a, 2b des Bauelements über, sondern schließen bündig mit diesen ab.

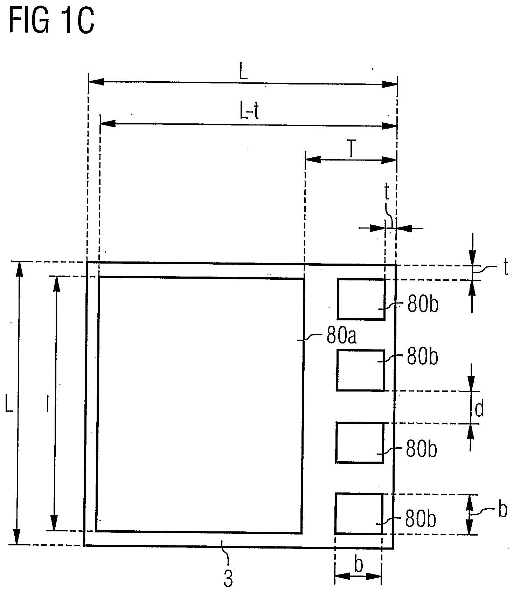

Figur 1c zeigt eine Aufsicht auf die Montagefläche 3 eines weiteren Ausführungsbeispiels eines der hier beschriebenen optoelektronischen Bauelemente. Beispielsweise kann es sich um die Unterseite eines Bauelements gemäß oder ähnlich der Figuren 1a oder 1b handeln.

Auf der Unterseite des oberflächenmontierbaren Bauelements an der Montagefläche 3, die durch eine Oberfläche des Formkörpers 2 gebildet ist, sind die Anschlussflächen 80a, 80b der Anschlussstellen 4a, 4b frei zugänglich. Beispielsweise sind diese Anschlussstellen mit einer oben beschriebenen Beschichtung 8a, 8b versehen.

Die Anschlussstellen 4b können dabei durch eine Mehrzahl von Anschlussstellen - im Ausführungsbeispiel der Figur 1c sind es vier Anschlussstellen 4b - gegeben sein. Die Anschlussstellen 4a und 4b des Bauelements sind dann unterschiedlich dimensioniert. Das heißt, das Bauelement weist unterschiedlich dimensionierte Anschlussstellen 4a, 4b auf. Es ist aber auch möglich, dass lediglich eine einzelne zweite Anschlussstelle 4b vorhanden ist, deren Anschlussfläche 80b beispielsweise die gleichen Abmessungen wie die Anschlussfläche 80b der ersten Anschlussstelle 4a aufweisen kann.

Im Ausführungsbeispiel der Figur 1c beträgt die Länge der Anschlussstellen 4a 1 = 1,7 +/- 0,035 Millimeter. Die Länge L des Bauelements beträgt 1,8 +/- 0,05 Millimeter. Die Breite der Anschlussfläche 80a beträgt l - T = 1,15 +/- 0,05 Millimeter. Der Abstand der Anschlussflächen 80a, 80b von den Seitenflächen 2a, 2b des Bauelements beträgt t = 0,05 +/-0,03 Millimeter. Der Abstand der Anschlussflächen 80b voneinander beträgt D = 0,2 +/- 0,05 Millimeter. Die Breite der Anschlussflächen 80b beträgt b = 0,275 +/- 0,05 Millimeter.

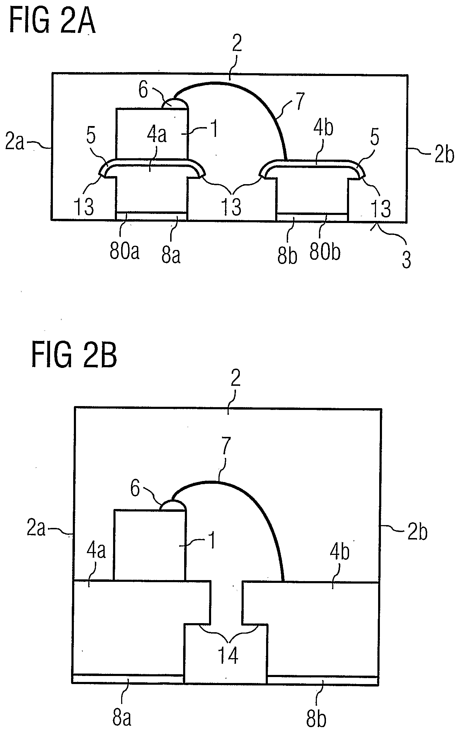

Die Figuren 2a und 2b zeigen schematische Schnittdarstellungen eines weiteren Ausführungsbeispiels des hier beschriebenen oberflächenmontierbaren Bauelements und eines Beispiels für ein anderes Bauelement. Im Ausführungsbeispiel der Figur 2a wie auch im Beispiel der Figur 2b schließen die Beschichtungen 8a, 8b der Anschlussflächen 80a, 80b des Bauelements bündig mit der Montagefläche 3 ab. Die Anschlussflächen 80a, 80b der Anschlussstellen 4a, 4b sind daher in einer Ausnehmung der Montagefläche 3 angeordnet.

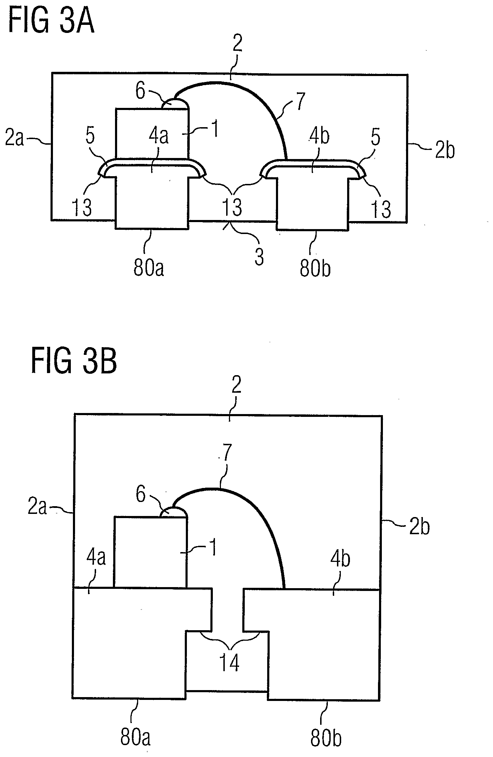

Die Figuren 3a und 3b zeigen schematische Schnittdarstellungen von weiteren Beispielen von oberflächenmontierbaren Bauelementen. In diesen Beispielen ragen die Anschlussstellen 4a, 4b leicht über die Montagefläche 3 hinaus. Die Anschlussflächen 80a, 80b der Anschlussstellen 4a, 4b sind außerhalb des Formkörpers 2 angeordnet. Der Überstand der Anschlussflächen 4a, 4b ist dabei gering im Verhältnis zur Höhe des Formkörpers 2.

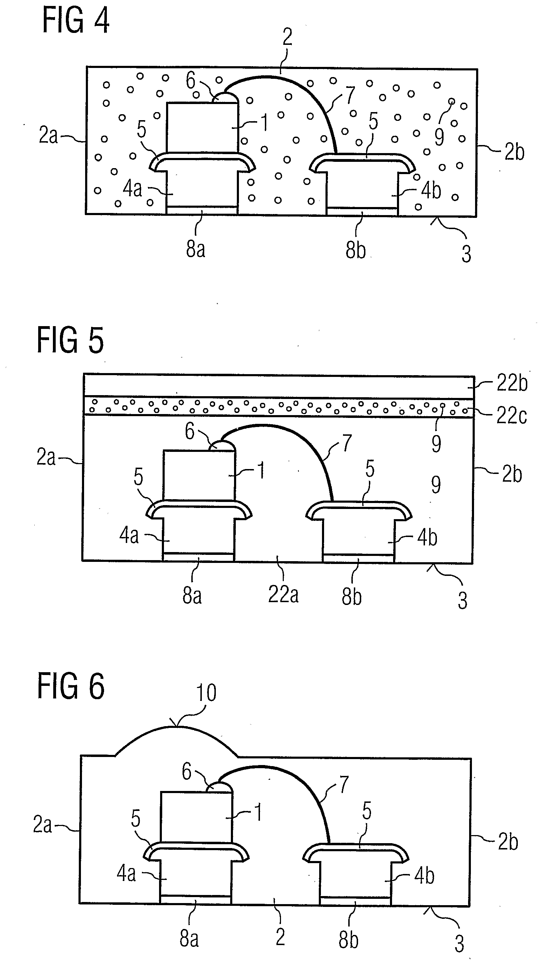

Figur 4 zeigt ein weiteres Ausführungsbeispiel des hier beschriebenen oberflächenmontierbaren optoelektronischen Bauelements. In Ergänzung beispielsweise zum in Zusammenhang mit Figur 2a beschriebenen Ausführungsbeispiel des Bauelements ist in Formkörper 2 hier ein weiteres Material 9 vorhanden. Bei dem weiteren Material 9 handelt es sich zum Beispiel um Partikel die geeignet sind, elektromagnetische Strahlung zu streuen - Diffuserpartikel -, zu absorbieren - Absorber - oder Wellenlängen zu konvertieren - Leuchtstoffe.

Weiter ist es möglich, dass der Formkörper 2 zumindest zwei dieser Partikelsorten enthält. Das heißt, der Formkörper 2 kann zum Beispiel Diffuserpartikel und Leuchtstoffpartikel aufweisen.

Handelt es sich beim Material 9 beispielsweise um Leuchtstoffpartikel eines Lumineszenzkonversionsmaterials, dann kann das optoelektronische Bauelement geeignet sein, weißes Licht zu emittieren.

Figur 5 zeigt ein weiteres Ausführungsbeispiel des hier beschriebenen optoelektronischen Bauelements. Im Ausführungsbeispiel der Figur 5 ist das zusätzliche Material 9 in einer Schicht 22c angeordnet. Zum Beispiel handelt es sich bei der Schicht 22c um eine Schicht des Formkörpers 2, die Leuchtstoffpartikel enthält. Das Bauelement gemäß dem Ausführungsbeispiel der Figur 5 weist zudem eine Schicht 22a des Formkörpers 2 auf, die frei von dem weiteren Material 9 ist, und den Halbleiterchip 2 einfasst. Weiter weist das Bauelement eine Schicht 22b auf, die ebenfalls kein weiteres Material 9 enthält. Die Schicht 22b ist durch die Oberfläche des Bauelements begrenzt, die der Montagefläche 3 des Bauelements abgewandt ist.

Figur 6 zeigt ein weiteres Ausführungsbeispiel des hier beschriebenen oberflächenmontierbaren optoelektronischen Bauelements. In diesem Ausführungsbeispiel ist die Strahlungsdurchtrittsfläche 10 des Bauelements linsenartig ausgebildet. Dazu kann die Strahlungsdurchtrittsfläche zumindest stellenweise nach Art einer sphärischen, elliptischen oder asphärischen Linse gewölbt sein. Ferner ist es möglich, dass die Strahlungsdurchtrittsfläche zumindest stellenweise nach Art einer Fresnel-Linse, einer Zonenoptik oder einer holografischen Optik ausgebildet ist. Die Strukturierung der Strahlungsdurchtrittsfläche 10 kann dabei zum einen der Strahlformung von in das Bauelement eintretender oder aus dem Bauelement austretender Strahlung vorgesehen sein. Zum anderen ist es möglich, dass sich durch die Ausgestaltung der Strahlungsdurchtrittsfläche die Wahrscheinlichkeit für Totalreflexion an der Strahlungsdurchtrittsfläche 10 verringert. Auf diese Weise kann mehr Licht in das Bauelement ein- oder ausgekoppelt werden.

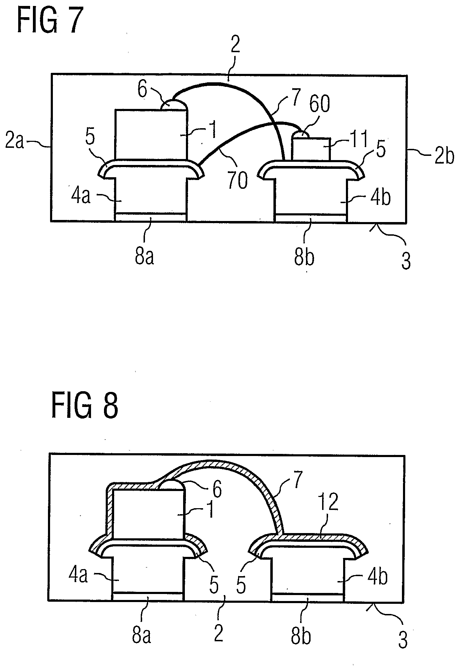

Figur 7 zeigt ein weiteres Ausführungsbeispiel des hier beschriebenen oberflächenmontierbaren Bauelements. Im Ausführungsbeispiel der Figur 7 ist dem Halbleiterchip 1 ein ESD-Schutzelement parallel geschaltet. Beispielsweise ist dem Halbleiterchip 1 eine Leuchtdiode 11 als ESD-Schutzelement antiparallel geschaltet. Die Leuchtdiode 11 ist dazu auf der Montagefläche der zweiten Anschlussstelle 4b aufgebracht und durch einen Kontaktierungsdraht 70 mit der ersten Anschlussstelle 4a verbunden. Der Kontaktierungsdraht 70 kann beispielsweise mittels eines Bondpads 60 mit der Leuchtdiode 11 kontaktiert sein. Die Leuchtdiode 11 kann neben einer Eigenschaft als ESD-Schutzelement für den optoelektronischen Halbleiterchip 1 auch zur Strahlungserzeugung dienen. Dazu kann an die Anschlussstellen 4a, 4b beispielsweise Strom wechselnder Richtung mittels einer Pulsweitenmodulationsschaltung angelegt sein. Dies erweist sich beispielsweise besonders vorteilhaft, wenn es sich beim Halbleiterchip 1 selbst um eine Leuchtdiode handelt und der Formkörper 2 ein Lumineszenzkonversionsmaterial enthält. Das Bauelement ist dann beispielsweise durch Mischung des blauen Lichts des optoelektronischen Halbleiterchips 1 und dem wellenlängenkonvertierten Anteil der Strahlung - beispielsweise gelbes Licht - geeignet, weißes Licht zu erzeugen. Die Leuchtdiode 11 kann dann geeignet sein, Licht zu erzeugen, das den Farbwiedergabeindex des vom Bauelement emittierten Lichts erhöht. Beispielsweise handelt es sich dabei um rotes Licht.

Alternativ zu einer Leuchtdiode 11 kann das ESD-Schutzelement auch durch eines der folgenden Komponenten gegeben sein: Varistor, Widerstand, Zener-Diode.

In Verbindung mit Figur 8 ist ein weiteres Ausführungsbeispiel des hier angegebenen oberflächenmontierbaren Bauelements angegeben. In diesem Ausführungsbeispiel ist auf die Komponenten des Bauelements zumindest stellenweise eine Beschichtung 12 aufgebracht, die ein Material enthält, das die Haftung der Komponenten wie Anschlussstellen 4a, 4b, optoelektronischem Halbleiterchip 1, Kontaktierungsdraht 7 an den Formkörper 2 verbessert. Das heißt, diese Beschichtung 12 dient zur Vermeidung eines Delaminierens des Formkörpers 2 von den Komponenten des Bauelements.

Bevorzugt enthält die Beschichtung 12 ein Silikat. Sie kann beispielsweise mittels Flammenpyrolyse auf zumindest einzelne Komponenten des Bauelements aufgebracht sein. Die Schichtdicke der Beschichtung 12 beträgt maximal 40 Nanometer, bevorzugt maximal 20 Nanometer, besonders bevorzugt maximal 5 Nanometer. Die Beschichtung 12 zeichnet sich durch eine starke Haftkraft an die Komponenten des Bauelements und eine hohe Oberflächenenergie aus. Die Schicht 12 ist dadurch geeignet, eine Haftung zwischen den Komponenten und dem Formkörper 2, der die Schicht 12 bevorzugt vollständig benetzt, zu vermitteln.

Beispielsweise kann es sich bei dem Silikat um ein stöchiometrisches Silikat oder um ein nicht stöchiometrisches Silikat (SiₓO_{y}) handeln. Weiter kann das Silikat organische Seitengruppen, zumindest eine organische Seitengruppe umfassen, wie zum Beispiel eine der folgenden Seitengruppen: Vinyl, Epoxy, Amino.

Ferner sind alternativ zu den genannten Silikatarten auch andere Materialien als Haftvermittler denkbar. In Frage kommen beispielsweise oxidische Schichten anderer Halbleiter oder Metalle.

An dieser Stelle sei darauf hingewiesen, dass insbesondere auch Kombinationen der Ausgestaltungen der Ausführungsbeispiele der Figuren 4 bis 8 möglich sind. Insbesondere können diese Ausgestaltungen in den Ausführungsbeispielen der Figuren 1a, 1c und 2a Anwendung finden.

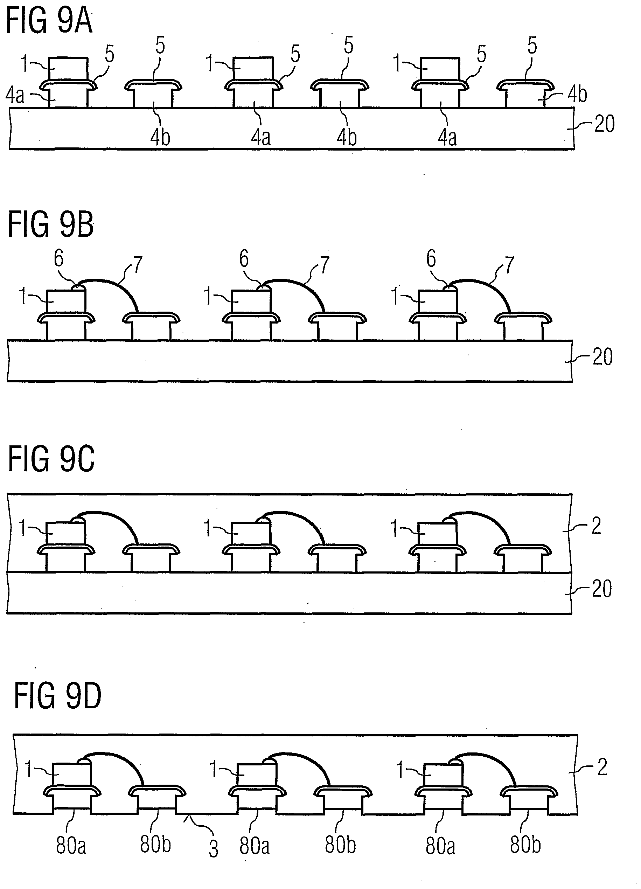

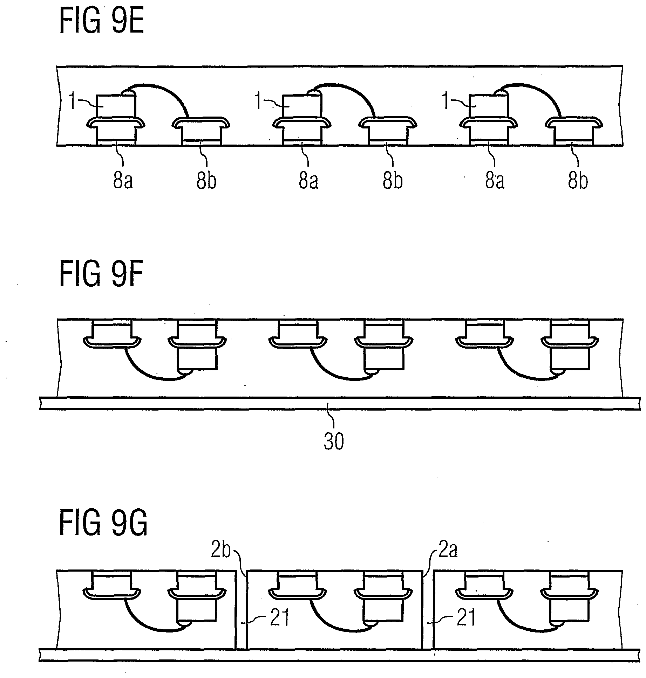

In Verbindung mit den Figuren 9a bis 9g ist ein Ausführungsbeispiel des hier beschriebenen Verfahrens angegeben. Das Herstellungsverfahren ist zur Herstellung eines Ausführungsbeispiels des Bauelements wie es in Verbindung mit Figur 2a beschrieben ist, geeignet. Das Verfahren kann prinzipiell aber zur Herstellung aller hier beschriebenen Ausführungsbeispiele des Bauelements Verwendung finden. In den Figuren 9a bis 9g ist das Verfahren mittels schematischer Schnittdarstellungen erläutert.

Wie in Figur 9a gezeigt, wird zunächst ein Substrat 20 mit einer Vielzahl von Anschlussstellen 4a, 4b zur Verfügung gestellt. Die Anschlussstellen 4a, 4b sind dabei einem zweidimensionalen Array angeordnet, von dem in den Schnittdarstellungen der Figuren 9a bis 9g lediglich eine Reihe oder Zeile gezeigt ist. Das Substrat 20 besteht beispielsweise aus Kupfer oder enthält Kupfer. Es ist bevorzugt wenigstens 120 *µ*m dick.

Die Anschlussstellen 4a, 4b werden zunächst mit einer Beschichtung 5 versehen, die zum Beispiel Gold enthält. Die Beschichtung 5 verbessert die Kontaktierbarkeit des optoelektronischen Halbleiterchips 1 und des Kontaktierungsdrahts 7 an den Anschlussstellen 4a, 4b. Auf die Anschlussstelle 4a wird im Folgenden ein optoelektronischer Halbleiterchip 1 aufgebondet, leitend aufgeklebt oder aufgelötet. Die optoelektronischen Halbleiterchips 1 sind beispielsweise mit ihren p-Seiten auf die Anschlussstellen 4a aufgebondet.

Im Folgenden (Figur 9b) werden die optoelektronischen Halbleiterchips 1 zum Beispiel n-seitig mittels eines Bondpads 9 an einen Kontaktierungsdraht 7 mit den Anschlussstellen 4a elektrisch leitend verbunden.

Beispielsweise im Anschluss kann eine Silikatbeschichtung 12 (aus Gründen der Übersichtlichkeit nicht dargestellt) auf die Komponenten des Bauelements aufgebracht werden. Die Silikatbeschichtung 12 kann zum Beispiel mittels Flammenpyrolyse auf die Komponenten aufgebracht werden.

Im Folgenden werden die Komponenten des Bauelements zum Erzeugen eines Formkörpers 2 in die Kavität eines Guss- oder Presswerkzeuges eingebracht. Eine Formmasse wird dann mittels Spritzpressen oder Spritzgießen in die Kavität des Werkzeuges eingefüllt. Bei der Formmasse handelt es sich um eine epoxid- oder silikonhaltige Formmasse. Bevorzugt handelt es sich bei der Formmasse um ein Epoxid-Silikon-Hybrid-Material. Silikone beziehungsweise Hybrid-Materialen, die Silikone enthalten, weisen eine relativ niedrige Viskosität auf. Bei Verarbeitung in Einzelkavitäten erhöht sich dadurch die Flashneigung der Materialien vor allem in Verbindung mit Leadframe-basierten Bauelementen da die Abdichtung zwischen Leadframe oder Substrat 20 und der Metalloberfläche des Werkzeuges schwierig ist. In diesem Fall ist eine Vielzahl von Schließflächen vorhanden, die Dickenschwankungen und Schwankungen der Oberflächenrauhigkeiten innerhalb des Substrats 20 können in einem Werkzeug kaum ausgeglichen werden. Weiter sind Silikone beziehungsweise Hybrid-Materialien, die ein Silikon enthalten, erfahrungsgemäß spröder als Epoxidharz-basierte Pressmassen. Dadurch ergibt sich ein sehr kleines Prozessfenster bei Deflash-Verfahren wie zum Beispiel beim elektrolytischen Deflashen oder Wasserstrahldeflashen. Ein Vergießen einer Vielzahl von Bauelementen in einer gemeinsamen Kavität erweist sich daher bei diesen Materialien als besonders vorteilhaft.

Weiter kann beim Spritzpressen des Formkörpers 2 ein Folienmolding-Prozess zum Einsatz kommen. Dabei wird die Kavität des Werkzeugs mit einer Folie ausgelegt, die eine geringe Haftung zur verwendeten Formmasse aufweist. Es kann in diesem Fall auf ein Formtrennmittel verzichtet werden. Dadurch erhöht sich die Haftung des Formkörpers an die Komponenten des Bauelements.

Im nachfolgenden Verfahrensschritt wird wie in Figur 9d gezeigt, das Substrat 20 der Anschlussstellen 4a, 4b entfernt. Dies kann beispielsweise durch einen Ätzprozess erfolgen.

In einem weiteren, in Verbindung mit 9e gezeigten Verfahrensschritt, wird eine Lotschicht 8a, 8b auf die Anschlussflächen 80a, 80b der Anschlussstellen 4a, 4b aufgebracht, die bündig mit der Montagefläche 3 des Bauelements abschließt oder diese überragt.

Figur 9f zeigt das Array von Bauelementen zur weiteren Bearbeitung auf eine Folie auflaminiert.

Figur 9g zeigt das Vereinzeln der Bauelemente, das beispielsweise mittels Sägen, Schneiden, Laserschneiden, Wasserstrahlschneiden oder Brechen erfolgen kann.

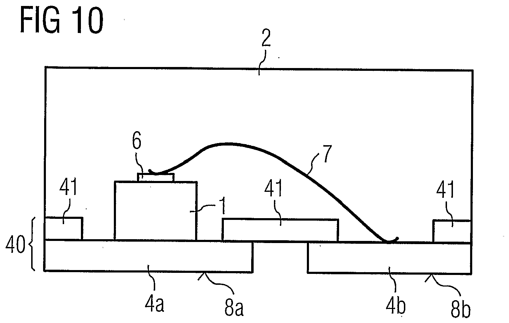

Alternativ zu Anschlussflächen 4a, 4b auf einem Kupfersubstrat 20 kann ein gemeinsames Vergießen auch auf einer Folie 40 erfolgen, die eine Kunststofffolie 41 und eine auf die Kunststofffolie 41 auflaminierte Kupferfolie umfasst. Ein Beispiel eines solchen Bauelements ist in Figur 10 gezeigt. Die Kupferfolie ist mittels fototechnischer und ätztechnischer Prozessschritte zu Anschlussstellen 4a, 4b prozessiert.

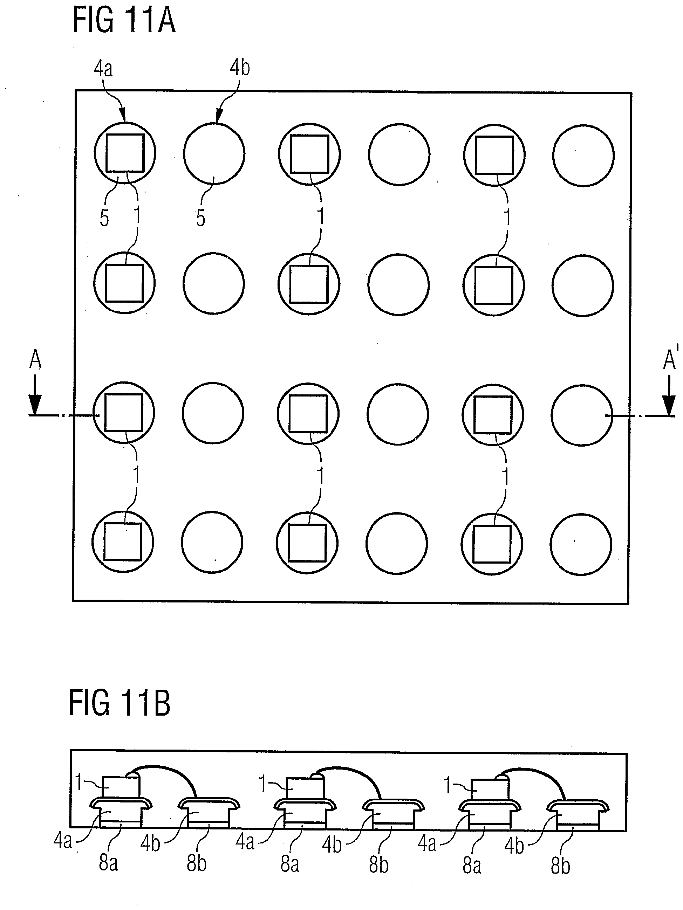

Die Figur 11a zeigt eine schematische Draufsicht eines weiteren Ausführungsbeispiels des hier beschriebenen oberflächenmontierbaren Bauelements.

Die Figur 11b zeigt eine schematische Schnittdarstellung entlang der Linie A-A' des in Verbindung mit der Figur 11a beschriebenen oberflächenmontierbaren Bauelements.

Wie der schematischen Draufsicht der Figur 11a zu entnehmen ist, weist das oberflächenmontierbare Bauelement gemäß diesem Ausführungsbeispiel eine Mehrzahl von optoelektronischen Halbleiterchips 1 auf. Die optoelektronischen Halbleiterchips sind dabei matrixartig angeordnet. Das heißt, die optoelektronischen Halbleiterchips 1 sind in Zeilen und Spalten angeordnet. Dabei ist es möglich, dass es sich bei den optoelektronischen Halbleiterchips 1 um gleichartige Halbleiterchips handelt, die im Wesentlichen elektromagnetische Strahlung des gleichen Wellenlängenbereichs emittieren oder detektieren. Weiter ist es möglich, dass sich zumindest zwei der optoelektronischen Halbleiterchips 1 hinsichtlich des Wellenlängenbereichs, in dem sie elektromagnetische Strahlung emittieren oder detektieren, unterscheiden.

Beispielsweise kann das in Verbindung mit den Figuren 11a und 11b erläuterte oberflächenmontierbare Bauelement eine Flächenlichtquelle bilden. Die einzelnen optoelektronischen Halbleiterchips 1 sind dann zum Beispiel durch Lumineszenzdiodenchips gebildet. Durch das Einbringen von Diffuserpartikeln in den Formkörper oder durch das diffus streuende Ausbilden der Strahlungsaustrittsfläche des oberflächenmontierbaren Bauelements - beispielsweise durch Aufrauen der Strahlungsaustrittsfläche - kann der Eindruck erzeugt werden, als handle es sich bei der Strahlungsaustrittsfläche des optoelektronischen Bauelements um eine einzige, homogen leuchtende Fläche. Die einzelnen optoelektronischen Halbleiterchips 1 sind dann nicht mehr getrennt voneinander wahrnehmbar. Handelt es sich bei den optoelektronischen Halbleiterchips 1 beispielsweise um Lumineszenzdiodenchips, die geeignet sind, Licht voneinander unterschiedlicher Farbe zu emittieren, so kann vom oberflächenmontierbaren Bauelement Mischlicht ausgesandt werden.

## Patentansprüche

1. Verfahren zur Herstellung eines oberflächenmontierbaren optoelektronischen Bauelements mit einem optoelektronischen Halbleiterchip (1) auf einer Anschlussstelle (4a, 4b), bei dem
- ein Substrat (20) mit einer Vielzahl von Anschlussstellen (4a, 4b) bereitgestellt wird, wobei die Anschlussstellen (4a, 4b) pilzförmig ausgebildet sind,
- eine Vielzahl von optoelektronischen Halbleiterchips (1) auf Anschlussstellen (4a, 4b) aufgebondet, leitend aufgeklebt oder aufgelötet werden,
- die Vielzahl der optoelektronischen Halbleiterchips (1) auf den Anschlussstellen (4a, 4b) in einer Kavität eines Presswerkzeugs oder eines Gusswerkzeugs angeordnet wird,
- die Halbleiterchips (1) mit einem gemeinsamen Formkörper (2) umhüllt werden durch Vergießen oder Umspritzen der optoelektronischen Halbleiterchips (1) zusammen mit den Anschlussstellen (4a, 4b), so dass die Anschlussstellen (4a, 4b) zumindest stellenweise vom Formkörper (2) eingefasst werden,
- das Substrat (20) nach dem Umhüllen entfernt wird, so dass Anschlussflächen (80a, 80b) der Anschlussstellen (4a, 4b) und eine Montagefläche (3), die zumindest stellenweise durch eine Oberfläche des Formkörpers (2) gebildet ist, freigelegt werden,
- der Formkörper (2) zur Vereinzelung der Bauelemente durchtrennt wird, wobei ein Materialabtrag stattfindet, so dass Seitenflächen (2a, 2b) der Bauelemente erzeugt werden, die Spuren des Materialabtrags aufweisen, und
- bei dem im Bauelement der Halbleiterchip (1) von außerhalb des optoelektronischen Bauelements über die Anschlussfläche (80a, 80b) kontaktierbar ist.

2. Verfahren nach dem vorherigen Anspruch,
wobei zum Vereinzeln der Bauelemente ausschließlich der Formkörper (2) durchtrennt wird.

3. Verfahren nach Anspruch 1 oder 2,
wobei der Formkörper (2) eines der folgenden Materialien enthält: Epoxid, Silikon, Epoxid-Silikon-Hybridmaterial.

4. Verfahren nach Anspruch 3,
wobei die Materialien reaktionshärtend sind.

5. Verfahren nach einem der Ansprüche 1 bis 4,
wobei vor dem Umhüllen mit dem Formkörper (2) Komponenten des Bauelements (1, 4a, 4b, 11, 7, 70) mit einem Material (12) beschichtet werden, das geeignet ist, die Haftung zum Formkörper (2) zu erhöhen.

6. Verfahren nach Anspruch 5,
wobei das Material (12) ein Silikat umfasst.

7. Verfahren nach Anspruch 5 oder 6,
wobei die Beschichtung mittels Flammensilikatisierung erfolgt.

8. Verfahren nach einem der vorherigen Ansprüche,
bei dem der Formkörper (2) zumindest eines der folgenden Materialien (9) enthält: Licht streuende Partikel, Licht absorbierende Partikel, Glasfaser, Formtrennmittel.

9. Verfahren nach einem der vorherigen Ansprüche,
bei dem der Formkörper (2) ein Lumineszenzkonversionsmaterial enthält.

10. Verfahren nach einem der vorherigen Ansprüche,
bei dem der Formkörper (2) im Bauelement eine vom Halbleiterchip (1) entfernt liegende äußere Schicht (22b) und eine den Halbleiterchip einfassende innere Schicht (22a) aufweist, zwischen denen sich eine Schicht (22c) befindet, die ein zusätzlichen Material (9) enthält.

11. Verfahren nach dem vorherigen Anspruch,
bei dem innere (22a) und äußere Schicht (22b) frei von einem zusätzlichen Material (9) sind.

12. Verfahren nach einem der vorherigen Ansprüche,
bei dem der Formkörper (2) im Bauelement eine Strahlungsdurchtrittsfläche aufweist.

13. Verfahren nach dem vorherigen Anspruch,
bei dem die Strahlungsdurchtrittsfläche linsenartig ausgebildet ist.

14. Verfahren nach einem der vorherigen Ansprüche,
bei dem der Halbleiterchip (1) zur Strahlungserzeugung geeignet ist.

15. Verfahren nach einem der vorherigen Ansprüche,
bei dem der Halbleiterchip (1) zur Strahlungsdetektion geeignet ist.

16. Verfahren nach einem der vorherigen Ansprüche,
bei dem das Bauelement eine Mehrzahl von optoelektronischen Halbleiterchips (1) aufweist.

17. Verfahren nach dem vorherigen Anspruch,
bei dem die optoelektronischen Halbleiterchips (1) matrixartig angeordnet sind.

18. Verfahren nach einem der beiden vorherigen Ansprüche,
bei dem sich zumindest zwei der optoelektronischen Halbleiterchips (1) hinsichtlich der Wellenlänge der von ihnen im Betrieb emittierten oder detektierten elektromagnetischen Strahlung unterscheiden.

19. Verfahren nach einem der vorherigen Ansprüche,
bei dem die Anschlussstellen (4a, 4b) eine geätzte Struktur (14) in Form einer Unterätzung aufweisen, aufgrund derer die Anschlussstellen (4a, 4b) einen in Richtung von der Montagefläche (3) weggerichtet sprunghaft größer werdenden Durchmesser aufweisen.

20. Verfahren nach einem der vorherigen Ansprüche,
bei dem die optoelektronischen Halbleiterchips (1) auf Montageflächen (5) der Anschlussstellen (4a, 4b) befestigt werden.

21. Verfahren nach einem der vorherigen Ansprüche,
bei dem zumindest ein ESD-Schutzelement (11) für einen Halbleiterchip (1) auf einer Montagefläche (5) einer Anschlussstelle (4a, 4b) aufgebracht wird.

22. Verfahren nach dem vorherigen Anspruch,
bei dem als ESD-Schutzelement (11) eine Leuchtdiode vorgesehen ist, die zur Strahlungserzeugung geeignet ist.

23. Verfahren nach einem der vorherigen Ansprüche,
bei dem im Bauelement die Anschlussfläche (80a, 80b) einer Anschlussstelle (4a, 4b) bündig mit der Montagefläche (3) abschließt.

24. Verfahren nach einem der Ansprüche 1 bis 22,
bei dem im Bauelement die Anschlussfläche (80a, 80b) einer Anschlussstelle (4a, 4b) in einer Ausnehmung der Montagefläche (3) angeordnet ist.

25. Verfahren nach einem der vorherigen Ansprüche,
bei dem ein Kontaktierungsdraht (7), der zur elektrischen Kontaktierung eines Halbleiterchips (1) vorgesehen ist, mit einem Material (12) beschichtet wird, das geeignet ist, die Haftung an den Formkörper (2) zu verbessern.

26. Verfahren nach dem vorherigen Anspruch,
bei dem das Material (12) zur Verbesserung der Haftung ein Silikat enthält.

27. Verfahren nach dem vorherigen Anspruch,
bei dem das Material (12) eine Dicke von maximal 40 nm aufweist.

## Claims

1. A method for the production of a surface-mounted, optoelectronic device with an optoelectronic semiconductor chip (1) on a connection point (4a, 4b), in which
- a substrate (20) with a plurality of connection points (4a, 4b) is provided, wherein the connection points (4a, 4b) are configured in the form of mushrooms,
- a plurality of optoelectronic semiconductor chips (1) are bonded, conductively-adhered or soldered on to connection points (4a, 4b),
- the plurality of optoelectronic semiconductor chips (1) are arranged on the connection points (4a, 4b) in a cavity of a pressing tool or a molding tool,
- the semiconductor chips (1) are encapsulated with a common molded body (2) by potting or enmolding the optoelectronic semiconductor chips (1) together with the connection points (4a, 4b), so that the connection points (4a, 4b) are at least in places enclosed by the molded body (2),
- the substrate (20) is removed after encapsulation, so that connection surfaces (80a, 80b) of the connection points (4a, 4b) and a mounting surface (3), which is at least partially formed by a surface of the molded body (2), are exposed,
- the molded body (2) is severed for the singulation of the devices, wherein a material removal occurs, so that side surfaces (2a, 2b) of the devices are generated that exhibit traces of the material removal, and
- in which in the device, the semiconductor chip (1) can be contacted via the connection surface (80a, 80b) from outside the optoelectronic device.

2. The method according to the preceding claim,
wherein exclusively the molded body (2) is severed for the singulation of the devices.

3. The method according to claim 1 or 2,
wherein the molded body (2) contains one of the following materials: epoxy, silicone, epoxy silicone hybrid material.

4. The method according to claim 3,
wherein the materials are reaction-curing.

5. The method according to one of claims 1 to 4,
wherein, prior to the encapsulation with the molded body (2), components of the device (1, 4a, 4b, 11, 7, 70) are coated with a material (12), which is suitable to increase adhesion to the molded body (2).

6. The method according to claim 5,
wherein the material (12) includes a silicate.

7. The method according to claim 5 or 6,
wherein coating is effected by means of flame silication.

8. The method according to one of the preceding claims, in which the molded body (2) contains at least one of the following materials (9): light-scattering particles, light-absorbing particles, glass fiber, mold-release agents.

9. The method according to one of the preceding claims, in which the molded body (2) contains a luminescence conversion material.

10. The method according to one of the preceding claims, in which the molded body (2) in the device comprises an outer layer (22b) remote from the semiconductor chip (1) and an inner layer (22a) enclosing the semiconductor chip, between which a layer (22c) is located, that contains an additional material (9).

11. The method according to the preceding claim,
in which the inner (22a) and outer layer (22b) are free of an additional material (9).

12. The method according to one of the preceding claims, in which the molded body (2) comprises a radiation passage surface in the device.

13. The method according to the preceding claim,
in which the radiation passage surface is formed in the type of a lens.

14. The method according to one of the preceding claims,
in which the semiconductor chip (1) is suitable for the generation of radiation.

15. The method according to one of the preceding claims, in which the semiconductor chip (1) is suitable for the detection of radiation.

16. The method according to one of the preceding claims, in which the device comprises a plurality of optoelectronic semiconductor chips (1).

17. The method according to the preceding claim,
in which the optoelectronic semiconductor chips (1) are arranged in the type of a matrix.

18. The method according to one of the two preceding claims, in which at least two of the optoelectronic semiconductor chips (1) differ from one another in terms of the wavelength of the electromagnetic radiation emitted or detected during operation.

19. The method according to one of the preceding claims, in which the connection points (4a, 4b) comprise an etched pattern (14) in the form of an under-etching, due to which the connection points (4a, 4b) have an abruptly increasing diameter in a direction facing away from the mounting surface (3).

20. The method according to one of the preceding claims, in which the optoelectronic semiconductor chips (1) are fastened to mounting surfaces (5) of the connection points (4a, 4b).

21. The method according to one of the preceding claims, in which at least one ESD protective element (11) for one semiconductor chip (1) is applied on to a mounting surface (5) of a connection point (4a, 4b).

22. The method according to the preceding claim,
in which a light-emitting diode is provided as an ESD protective element (11), which is suitable for the generation of radiation.

23. The method according to one of the preceding claims,
in which in the device the connection surface (80a, 80b) of a connection point (4a, 4b) terminates flush with the mounting surface (3).

24. The method according to one of claims 1 to 22,
in which in the device the connection surface (80a, 80b) of a connection point (4a, 4b) is arranged in a recess of the mounting surface (3).

25. The method according to one of the preceding claims, in which a contacting wire (7), which is provided for the electrical contacting of a semiconductor chip (1), is coated with a material (12), which is suitable to improve adhesion to the molded body (2).

26. The method according to the preceding claim,
in which the material (12) contains a silicate for improving the adhesion.

27. The method according to the preceding claim,
in which the material (12) has a thickness of 40 nm at the most.

## Revendications

1. Procédé de fabrication d'un dispositif optoélectronique pouvant être monté en surface, comprenant une puce optoélectronique à semi-conducteur (1) sur un point de connexion (4a, 4b), dans lequel
- un substrat (20) comprenant une pluralité de points de connexion (4a, 4b) est fourni, les points de connexion (4a, 4b) étant réalisés en forme de champignons,
- une pluralité de puces optoélectroniques à semi-conducteur (1) sont bondérisées sur des points de connexion (4a, 4b), collées ou soudées de manière conductrice,
- la pluralité de puces optoélectroniques à semi-conducteur (1) sur les points de connexion (4a, 4b) est disposée dans une cavité d'un outil de pressage ou d'un outil de moulage,
- les puces à semi-conducteur (1) sont enveloppées par un corps façonné (2) commun par moulage ou surmoulage des puces optoélectroniques à semi-conducteur (1), en commun avec les points de connexion (4a, 4b), de sorte que les points de connexion (4a, 4b) sont bordés au moins en partie par le corps façonné (2),
- le substrat (20) est retiré après l'enveloppage, de sorte que des surfaces de connexion (80a, 80b) des points de connexion (4a, 4b) et une surface de montage (3), qui est formée au moins en partie par une surface du corps façonné (2), sont libérées,
- le corps façonné (2) est séparé dans le but d'individualiser les dispositifs, un enlèvement de matière ayant lieu, de sorte que des surfaces latérales (2a, 2b) des éléments sont générées, lesquelles présentent des traces de l'enlèvement de matière, et
- dans lequel, dans le dispositif, la puce à semi-conducteur (1) peut être mise en contact par l'intermédiaire de la surface de connexion (80a, 80b) depuis l'extérieur du dispositif optoélectronique.

2. Procédé selon la revendication précédente,
uniquement le corps façonné (2) étant séparé pour la division des dispositifs.

3. Procédé selon la revendication 1 ou 2,
le corps façonné (2) contenant l'un des matériaux suivants : époxyde, silicone, matériau hybride époxyde-silicone.

4. Procédé selon la revendication 3,
les matériaux durcissant par réaction.

5. Procédé selon l'une quelconque des revendications 1 à 4, des composants du dispositif (1, 4a, 4b, 11, 7, 70), avant l'enveloppage avec le corps façonné (2), étant revêtus d'un matériau qui est apte à augmenter l'adhérence au corps façonné (2).

6. Procédé selon la revendication 5,
le matériau (12) comprenant un silicate.

7. Procédé selon la revendication 5 ou 6,
le revêtement étant réalisé par silicatisation à la flamme.

8. Procédé selon l'une quelconque des revendications précédentes,
dans lequel le corps façonné (2) contient au moins une des matières (9) suivantes : particules diffusant la lumière, particules absorbant la lumière, fibres de verre, agents de démoulage.

9. Procédé selon l'une quelconque des revendications précédentes,
dans lequel le corps façonné (2) contient une matière de conversion par luminescence.

10. Procédé selon l'une quelconque des revendications précédentes,
dans lequel le corps façonné (2) dans le dispositif présente une couche extérieure (22b) située de manière éloignée de la puce à semi-conducteur (1) et une couche intérieure (22a) bordant la puce à semi-conducteur, entres lesquelles se trouve une couche (22c) qui contient un matériau supplémentaire (9).

11. Procédé selon la revendication précédente,
dans lequel la couche intérieure (22a) et la couche extérieure (22b) sont exemptes d'un matériau supplémentaire (9).

12. Procédé selon l'une quelconque des revendications précédentes,
dans lequel le corps façonné (2) dans l'élément présente une surface de passage de rayonnement.

13. Procédé selon la revendication précédente,
dans lequel la surface de passage de rayonnement est réalisée en forme de lentille.

14. Procédé selon l'une quelconque des revendications précédentes,
dans lequel la puce à semi-conducteur (1) est apte à générer un rayonnement.

15. Procédé selon l'une quelconque des revendications précédentes,
dans lequel la puce à semi-conducteur (1) est apte à détecter un rayonnement.

16. Procédé selon l'une quelconque des revendications précédentes,
dans lequel le dispositif présente une pluralité de puces optoélectroniques à semi-conducteur (1).

17. Procédé selon la revendication précédente,
dans lequel les puces optoélectroniques à semi-conducteur (1) sont disposées en forme de matrice.

18. Procédé selon l'une quelconque des deux revendications précédentes,
dans lequel au moins deux des puces optoélectroniques à semi-conducteur (1) se distinguent quant à la longueur d'onde du rayonnement électromagnétique émis ou détecté par elles en fonctionnement.

19. Procédé selon l'une quelconque des revendications précédentes,
dans lequel les points de connexion (4a, 4b) présentent une structure gravée (14) en forme d'une sous-gravure, en raison de laquelle les points de connexion (4a, 4b) présentent un diamètre grossissant fortement en direction détournée de la surface de montage (3).

20. Procédé selon l'une quelconque des revendications précédentes,
dans lequel les puces optoélectroniques à semi-conducteur (1) sont fixées sur des surfaces de montage (5) des points de connexion (4a, 4b).

21. Procédé selon l'une quelconque des revendications précédentes,
dans lequel au moins un élément de protection ESD (11) pour une puce à semi-conducteur (1) est placé sur une surface de montage (5) d'un point de connexion (4a, 4b).

22. Procédé selon la revendication précédente,
dans lequel une diode électroluminescente est prévue comme élément de protection ESD, laquelle est apte à générer un rayonnement.

23. Procédé selon l'une quelconque des revendications précédentes,
dans lequel dans le dispositif, la surface de connexion (80a, 80b) termine un point de connexion (4a, 4b) de manière affleurée avec la surface de montage (3).

24. Procédé selon l'une quelconque des revendications 1 à 22,
dans lequel dans le dispositif, la surface de connexion (80a, 80b) d'un point de connexion (4a, 4b) est disposée dans un évidement de la surface de montage (3).

25. Procédé selon l'une quelconque des revendications précédentes,
dans lequel un fil de mise en contact (7), lequel est ménagé pour la mise en contact électrique d'une puce à semi-conducteur (1), est revêtu d'une matière (12) qui est apte à améliorer l'adhérence au corps façonné (2).

26. Procédé selon la revendication précédente,
dans lequel la matière (12) destinée à améliorer l'adhérence contient un silicate.

27. Procédé selon la revendication précédente,
dans lequel la matière (12) présente une épaisseur de maximum 40 nm.
